# EUROPÄISCHE PATENTSCHRIFT

(11) **EP 3 930 130 B1**
(45) Veröffentlichungstag und Bekanntmachung des Hinweises auf die Patenterteilung: **12.02.2025**
(21) Anmeldenummer: 20182411.7
(22) Anmeldetag: 26.06.2020
(51) Int. Cl.: H02H 3/00, H02H 7/26, G01R 19/25, G05B 19/042

(54) **VERFAHREN ZUM PARAMETRIEREN EINER SCHUTZANORDNUNG, SCHUTZANORDNUNG UND COMPUTERPROGRAMMPRODUKT**
PROTECTIVE DEVICE AND COMPUTER PROGRAM PRODUCT, AND METHOD FOR PARAMETERIZING A PROTECTIVE DEVICE
PROCÉDÉ DE PARAMÉTRAGE D'UN AGENCEMENT DE PROTECTION, AGENCEMENT DE PROTECTION ET PRODUIT DE PROGRAMME INFORMATIQUE

(43) Veröffentlichungstag der Anmeldung: 29.12.2021
(73) Patentinhaber: Siemens Aktiengesellschaft, 80333 München (DE)
(72) Erfinder: Baumgärtel, Uwe, 13627 Berlin (DE); Loerke, Matthias, 16348 Basdorf (DE); Mieske, Frank, 13053 Berlin (DE); Stamminger, Stefan, 10247 Berlin (DE)
(74) Vertreter: Siemens Patent Attorneys

(56) Entgegenhaltungen:
- WO-A1-2008/104140
- WO-A1-2009/030258
- WO-A1-2012/013219
- WO-A2-2012/022374

## Beschreibung

Die Erfindung betrifft ein Verfahren gemäß dem Oberbegriff des Anspruchs 1, eine Schutzanordnung gemäß Anspruch 7 sowie ein Computerprogrammprodukt gemäß Anspruch 13.

In Energienetzen der Hoch- und Mittelspannungsebene werden elektrische Anlagen, wie z.B. Transformatoren oder Schaltanlagen, mittels Messeinrichtungen überwacht, die beispielsweise Spannungswerte und Stromwerte dreiphasig messen und bereitstellen. Eine gängige Bauform ist es, primäre Messwandler an der elektrischen Anlage einzusetzen, die analoge elektrische Größen wie Spannung und Stromstärke an Anschlussklemmen eines Schutzgeräts bereitstellen. Im Schutzgerät werden häufig sekundäre Messwandler für eine galvanische Trennung der Elektronik des Schutzgeräts eingesetzt.

Bei der Überwachung, der Steuerung und dem Schutz von elektrischen Energienetzen sind eine Vielzahl von verschiedenen Strömen und Spannungen in unterschiedlichen Anlagentopologien zu erfassen. In multifunktionalen Schutzgeräten werden unterschiedlichste Schutz-, Steuerungs- und Messaufgaben in einem Gerät realisiert. Weiterhin können von einem multifunktionalen Gerät mehrere Schutzobjekte geschützt werden.

Aus der Druckschrift WO 2008/104140 A1 ist es bekannt, eingehende analoge elektrische Signale an einer Mehrzahl von Messeingängen eines Schutzgeräts zu erfassen und zur Auswertung für softwarebasierte Schutzfunktionen sowie Schalterfunktionen auf einem Prozessor bereit zu stellen, wobei Vorverarbeitungseinrichtungen zur Übersetzung der analogen Eingangssignale in digitale Messwerte dienen.

Aus der Druckschrift WO 2009/030258 A1 ist es bekannt, eine Anschaltung bzw. Konfiguration konventioneller Strom- und Spannungswandler als sogenannte "instanziierbare Messwertmodule" an einem multifunktionalem Schutzgerät vorzunehmen. Bei den instanziierbaren Messwertmodulen handelt es sich um Softwarekomponenten, die bei der Projektierung bzw. Parametrierung eines Schutzgeräts eingestellt werden, um die analogen Eingangssignale der Anschlussklemmen des Schutzgeräts zu digitalisieren und den passenden Auswertungs- und Steuerungsfunktionen zuzuführen. Der Begriff instanziierbar stellt dabei darauf ab, dass die Messwertmodule als ein Grundtyp eines Messwertmoduls vordefiniert werden können, welcher danach mehrfach zur Parametrierung von z.B. mehreren zu überwachenden Objekten wiederverwendet werden kann (in Form von softwaremäßigen "Instanzen" des Grundtyps). Insbesondere werden instanziierbare Messmodule für Strom- und Spannungswandlereinheiten beschrieben, wobei die vier Grundtypen Strom 3-phasig, Strom 1-phasig, Spannung 3-phasig und Spannung 1-phasig zugrunde gelegt wurden.

Aus der Druckschrift WO 2012/022374 A2 ist ein Verfahren zum Parametrieren einer Schutzanordnung bekannt.

Ferner ist aus der Produktbroschüre "SIPROTEC 5 - V7.9 und V8.0 Schutz, Automatisierung und Überwachung von digitalen Schaltanlagen", Siemens AG 2019, von den Seiten 22 bis 32 bekannt, ein Schutzgerät per Prozessbus über Glasfaserkabel mit sogenannten "Merging Units", d.h. Datensammelungseinrichtungen, zu verbinden. Die Merging Units sind dabei analog per Kupferkabel an Messstellen einer elektrischen Anlage, z.B. einer gasisolierten Schaltanlage für Hochspannung über 1 kV, angeschlossen. Aus der Broschüre "SIPROTEC goes Process Bus - Volldigitale Schaltanlagen mit SIPROTEC" ist es bekannt, konventionelle bisherige Schaltanlagen mit einer Merging Unit zu verbinden, um analoge Messwerte wie Strom- und Spannungswerte (sog. "samples measured values" (SMV)) zu erfassen und diese als digitale Datentelegramme per Prozessbus zum Schutzgerät zu übermitteln. Der Prozessbus wird dabei entsprechend der Norm IEC 61850-9-2 betrieben.

Weiterhin ist aus der Ferner Produktbroschüre "SIPROTEC 5 Engineering Guide DIGSI 5 ab V6.0 Handbuch", Siemens AG 2015, Kennnummer C53000-G5000-C004-2, sowie aus "DIGSI 5 Software-Beschreibung V8.00 Hilfe", Siemens AG 2019, Kennnummer C53000-D5000-C001-G, eine Software zum Parametrieren von Schutzanordnungen bekannt.

Die Anschaltung der Strom- und Spannungswandler an das multifunktionale Schutzgerät erfolgt in der Prozessbusanbindung nicht mehr über die Geräteeingangsklemmen und Wandlung der analogen Signale in dem multifunktionalen Schutzgerät, sondern über o.g. Merging Units als digitale Messwandler.

Die digitalisierten Abtastwerte werden von den Merging Units zu dem Schutzgerät nach der Norm IEC 61850 9-2 übertragen und eine Auslösung von z.B. Leistungsschalters infolge einer Aktivierung einer Schutzfunktion im Schutzgerät erfolgt im Rahmen der Norm IEC 61850 GOOSE 8-1.

Das Verfahren der Übertragung der Abtastwerte über den Prozessbus ist standardisiert und in der Norm IEC 61850-9-2 Ed.2 Part 9-2 "Specific communication service mapping (SCSM) - Sampled Values over ISO/IEC 8802-3" beschrieben. Das Engineering, die Sprache, die Dateien und die verwendeten Tools z.B. das herstellerübergreifende Systemkonfigurationswerkzeug (im Folgenden auch als "System Configurator" bezeichnet) sind im Standard IEC 61850-6 beschrieben.

Ausgehend von bekannten Verfahren zum Parametrieren einer Schutzanordnung stellt sich an die Erfindung die Aufgabe, ein Verfahren anzugeben, mit dem eine Schutzanordnung vergleichsweise einfach, schnell und sicher in Betrieb zu nehmen ist.

Die Erfindung löst diese Aufgabe durch ein Verfahren gemäß Anspruch 1.

Ein elektrisches Energienetz ist beispielsweise ein Hochspannungsnetz mit über 52 kV Nennspannung, oder ein Mittelspannungsnetz mit 1 kV bis 52 kV Nennspannung. Solche Energienetze weisen Transformatoren an Leitungsabgängen auf, die z.B. im Hinblick auf Kurzschlüsse usw. überwacht werden müssen. Wird ein Fehler durch entsprechende Messungen entdeckt, so kann eine Schutzeinrichtung einen Schaltbefehl über eine Kommunikationsverbindung an einen Leistungsschalter übermitteln, der dann den Transformator und/oder die Leitung abschaltet.

Parametrieren im Sinne der Erfindung ist eine Vorgehensweise, bei der die Software eines oder mehrere Geräte für den Betrieb eingestellt wird.

Messeinrichtungen sind z.B. Spannungswandler und/oder Stromwandler, die entsprechend ihres Übersetzungsverhältnisses eine vergleichsweise kleine Ausgabespannung als analoges Ausgabesignal auf ihren Ausgabekanälen bzw. an ihren Ausgabeanschlüssen bereitstellen.

In modernen Anlagen werden diese analogen Signale nicht direkt an ein Schutzgerät übergeben, sondern in sog. "Merging Units" als Datensammelungseinrichtungen digitalisiert und zusammengefasst. Hierdurch wird eine Anbindung an eine digitale Datenkommunikationsinfrastruktur wie z.B. einen Prozessbus möglich.

Als erste Konfigurationseinrichtung kann beispielsweise die Software DIGSI der Siemens AG, die auf einem Rechner installiert ist, eingesetzt werden. Insbesondere kann ein sog. "Merging Unit Routing" im sog. "Merging Unit Engineering Tool" durchgeführt werden.

Als zweite Konfigurationseinrichtung für die Datenkommunikation kann ebenfalls DIGSI eingesetzt werden.

Auch als dritte Konfigurationseinrichtung kann DIGSI eingesetzt werden, um anhand eines Single-line Diagramms z.B. Strom- und Spannungswandler über einen Prozessbus-Client zu verschalten.

Damit kann die Funktionalität der drei Konfigurationseinrichtungen z.B. im Wesentlichen durch Software z.B. auf einem Rechner eines Technikers bereitgestellt werden. Lediglich der durch die Norm geforderte herstellerunabhängige System Configurator muss als separate Software vorgesehen werden.

Die Konfigurationseinrichtungen können lokal als Rechner mit Prozessor- und Datenspeichermitteln ausgebildet sein. Alternativ kann auch eine cloud-basierte Lösung vorsehen werden (sog. "Protection in the cloud"), bei der alle Schutzfunktionen als Softwareapplikationen bereitgestellt werden. Eine Cloud im Sinne der Erfindung ist ein Netzwerk aus Datenspeicher- und Prozessormitteln, die mittels eines Datenkommunikationsnetzwerks, wie z.B. des Internets, dezentral bereitgestellt werden.

In einer bevorzugten Ausführungsform des erfindungsgemäßen Verfahrens wird die parametrierte Schutzanordnung für den Betrieb des elektrischen Energienetzes eingesetzt, um mindestens einen Transformator und mindestens einen Leitungseingang zu überwachen und zu schützen.

Es wird für die Kommunikationsverbindungen Prozessbus verwendet. Dies ist ein Vorteil, weil Prozessbus weit verbreitet und erprobt ist sowie eine sichere digitale Datenübertragung ermöglicht.

In einer weiteren bevorzugten Ausführungsform des erfindungsgemäßen Verfahrens weisen die Kommunikationsverbindungen zwei redundante Prozessbusringe auf. Dies ist ein Vorteil, weil auch bei einem Ausfall eines Prozessbusringes durch den anderen Prozessbusring eine Überwachung und ein Schutz sichergestellt werden kann.

In einer weiteren bevorzugten Ausführungsform des erfindungsgemäßen Verfahrens erfolgt das Zuordnen der Ausgabekanäle von Messeinrichtungen zu Eingabekanälen der Datensammelungseinrichtung jeweils mittels Messwertmodulen, die Messwerte von dreiphasiger Spannung und/oder dreiphasigen Strom jeweils bündeln. Dies ist ein Vorteil, weil sich durch die Bündelung der Kanäle eine vereinfachte Parametrierung der Schutzanordnung ergibt. Beispielsweise muss nur ein Messwertmodul durchgehend durch die verschiedenen Konfigurationseinrichtungen behandelt werden anstatt 3 einzelne Messwertkanäle.

In einer weiteren bevorzugten Ausführungsform des erfindungsgemäßen Verfahrens werden die Messwertmodule in der Schutzeinrichtung für Schutzfunktionen verwendet. Dies ist ein Vorteil, weil sich durch die Bündelung der Kanäle zu Messwertmodulen auch bei der Konfiguration der Schutzfunktionen im Schutzgerät eine vereinfachte und schnellere Vorgehensweise ergibt.

In einer weiteren bevorzugten Ausführungsform des erfindungsgemäßen Verfahrens sind die Messwertmodule derart instanziierbar, dass mehrere elektrische Betriebsmittel über dieselbe Datensammelungseinrichtung und eine einziges Schutzeinrichtung überwacht und geschützt werden. Bei den instanziierbaren Messwertmodulen handelt es sich um Softwarekomponenten, die bei der Projektierung bzw. Parametrierung eines Schutzgeräts eingestellt werden, um die analogen Eingangssignale der Anschlussklemmen des Schutzgeräts zu digitalisieren und den passenden Auswertungs- und Steuerungsfunktionen zuzuführen. Der Begriff instanziierbar stellt dabei darauf ab, dass die Messwertmodule als ein Grundtyp eines Messwertmoduls vordefiniert werden können, welcher danach mehrfach zur Parametrierung von z.B. mehreren zu überwachenden Objekten wiederverwendet werden kann (in Form von softwaremäßigen "Instanzen" des Grundtyps). Insbesondere werden instanziierbare Messmodule für Strom- und Spannungswandlereinheiten beschrieben, wobei die vier Grundtypen Strom 3-phasig, Strom 1-phasig, Spannung 3-phasig und Spannung 1-phasig zugrunde gelegt wurden. Dies hat den Vorteil, dass eine durchgehende Behandlung der Messdaten von einer Merging Unit bis zu den Schutzfunktionen im Schutzgerät hin möglich wird, was die Parametrierung der Messstellenrangierung und der Schutzfunktionen wesentlich vereinfacht.

Ferner stellt sich, ausgehend von bekannten Schutzanordnungen, an die Erfindung die Aufgabe, eine Schutzanordnung anzugeben, die vergleichsweise einfach, schnell und sicher in Betrieb zu nehmen ist.

Die Erfindung löst diese Aufgabe durch ein Verfahren gemäß Anspruch 7. Bevorzugte Ausführungsformen ergeben sich aus den abhängigen Ansprüchen 8 bis 12. Dabei ergeben sich sinngemäß die gleichen Vorteile wie eingangs für das erfindungsgemäße Verfahren erläutert.

Ferner stellt sich an die Erfindung die Aufgabe, ein Computerprogrammprodukt anzugeben, mit dem eine Schutzanordnung vergleichsweise einfach, schnell und sicher in Betrieb zu nehmen ist.

Die Erfindung löst diese Aufgabe durch ein Computerprogrammprodukt gemäß Anspruch 13. Es ergeben sich sinngemäß die gleichen Vorteile wie eingangs für das erfindungsgemäße Verfahren erläutert.

Zur besseren Erläuterung der Erfindung zeigen in schematischer Darstellung die
- Figur 1: ein bekanntes Ausführungsbeispiel einer Zuordnung von Messwandlern eines elektrischen Energienetzes zu Funktionsgruppen eines Schutzgeräts, und
- Figur 2: ein Ausführungsbeispiel für eine per Prozessbus verschaltete Schutzanordnung, und
- Figur 3: einen bekannten Ablaufplan für eine Konfiguration einer Schutzanordnung, und
- Figur 4: eine Ausführungsbeispiel einer bekannten Zuordnung von Messwandlerkanälen zu einer Datensammelungseinrichtung und einer Schutzeinrichtung, und
- Figur 5: ein Ausführungsbeispiel einer erfindungsgemäßen Messstellenrangierung mit Prozessbus, und
- Figur 6: ein Ausführungsbeispiel für eine erfindungsgemäße graphische Zuordnung von Messeinrichtungen und eine Parametrierung der Kommunikationsverbindungen anhand eines Single-line Diagramms.

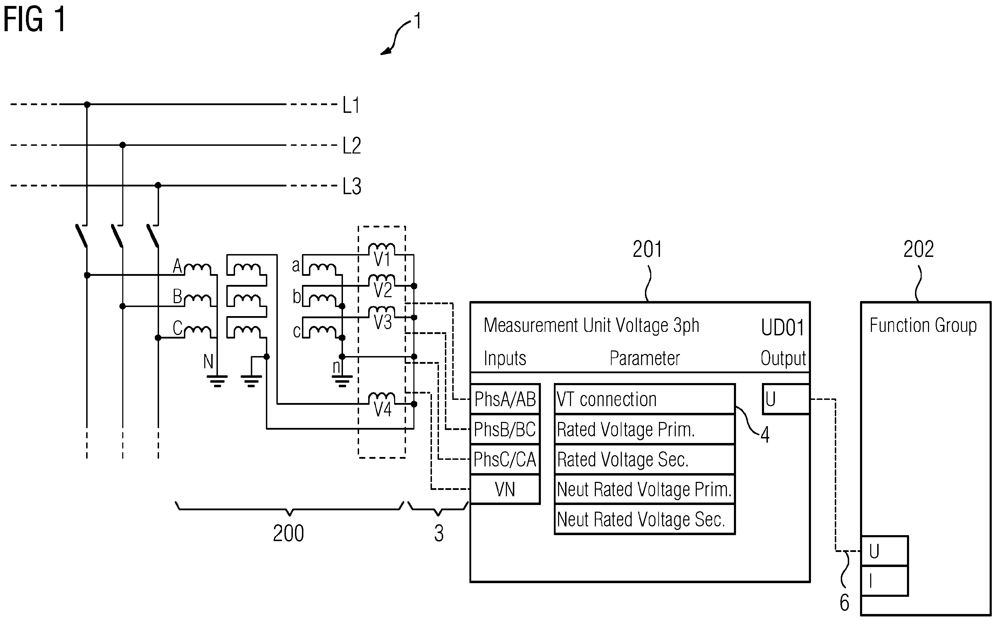

Die Figur 1 zeigt ein bekanntes Ausführungsbeispiel einer Zuordnung von Messwandlern A,B,C eines elektrischen Energienetzes mit den drei Phasen L1,L2,L3 zu Funktionsgruppen 202 eines Schutzgeräts. Primäre Messwandler A,B,C sind mit jeweils einer Phase L1,L2,L3 des Energienetzes verbunden. Sie stellen eine Messspannung für jede Phase L1,L2,L3 an ein Schutzgerät (gestrichelter Kasten um die internen sekundären Messwandler für die Spannungen V1,V2,V3,V4) bereit. Primäre Messwandler A,B,C und das Schutzgerät bilden zusammen eine Schutzanordnung 200.

Das Schutzgerät weist Prozessor- und Datenspeichermittel auf, so dass eine Messstellenrangierung für die analogen Eingangssignale vorgenommen werden kann. Die Spannungen V1...V4 werden softwareseitig als dreiphasiges Messwertmodul 201 bereitgestellt und den Eingängen PhsA/AB, PhsB/BC, PhsC/CA, VN (Neutral) zugeordnet. Im Messwertmodul 201 wird als Art der Messung "VT connection" 4 festgelegt ("VT" für "voltage transformer"). Die Ortsnetzstation, der das Schutzgerät zugeordnet ist, wird mit "UD01" 5 bezeichnet. Das dreiphasige Messwertmodul stellt die Spannungen softwaremäßig verschiedenen Schutzfunktionen als Eingangsgrößen bereit (angedeutet durch das Bezugszeichen 6). Die Konfiguration des Messwertmoduls und der Schutzfunktionen erfolgt typischerweise durch einen Techniker mittels eines sog. "Engineering Tools".

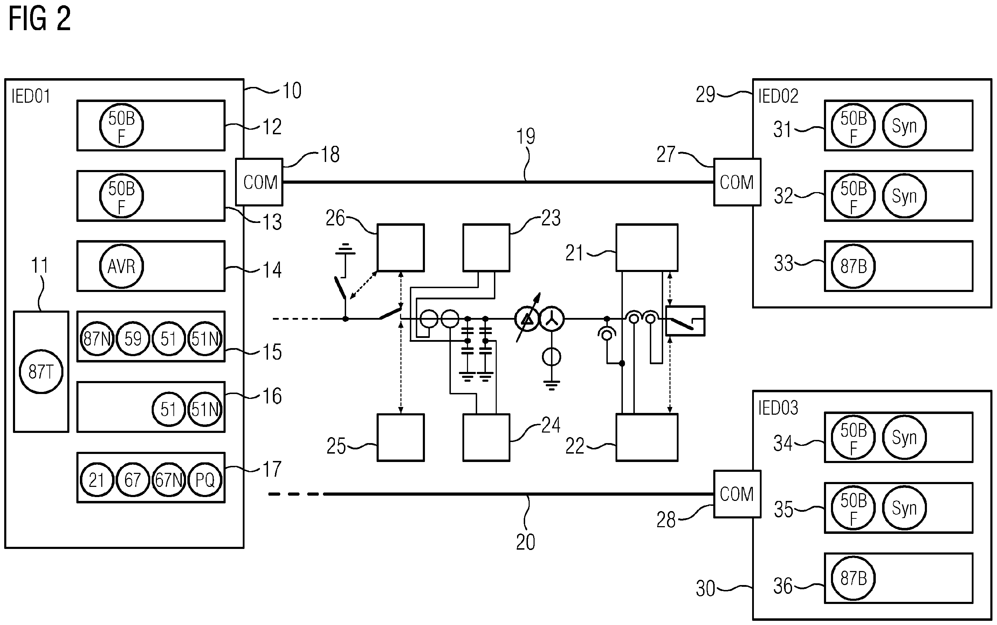

Figur 2 zeigt ein Ausführungsbeispiel für eine per Prozessbus verschaltete Schutzanordnung. Mittig in der Abbildung ist ein elektrisches Beispielnetz gezeigt, bei dem an mehreren Messtellen Messwandler als Messeinrichtungen vorgesehen sind. Diese Messeinrichtungen sind per analoge Kabelverbindung mit Datensammelungseinrichtungen 21,22,23,24 verbunden, die auch als sog. "Merging Units" bezeichnet werden. Ferner sind sog. I_O_Module 25,26 für einen Leistungsschalter und einen Erdungsschalter vorgesehen, die jeweils binär die Schalterstellung (offen/geschlossen) erfassen.

Die Datensammelungseinrichtungen 21,22,23,24 sowie die I_O_Module 25,26 sind redundant, per digitaler Datenkommunikation, an zwei Prozessbusringe 19,20 angeschlossen. Beispielsweise handelt es sich bei den Prozessbusringen um Datenkabel, die ein Versenden von sog. GOOSE-Nachrichten für u.a. Leistungs- und Blindleistungswerte, Steuerbefehle, Regelungsbefehle und Schutzfunktionen ermöglichen. Hierfür weisen die Datensammelungseinrichtungen 21,22,23,24 sowie die Steuergeräte 25,26 jeweils Kommunikationseinrichtungen für Prozessbus auf.

Es sind drei "Intelligent Electronic Devices " (IED01, IED02, IED03) 10,29,30 vorgesehen, die jeweils z.B. Schutzfunktionen bereitstellen können. Bei den IEDs kann es sich z.B. um Schutz- und Steuergeräte des eingangs erwähnten Typs Siemens SIPROTEC 5 handeln.

Beispielsweise weist das Gerät 10 mehrere in Software ausgebildete Schutzfunktionsgruppen 11-17 auf, zu denen jeweils die in der Schutztechnik typischen Funktionsbezeichner, die sog. "American National Standards Institute" (ANSI) - Nummern, wie z.B. 87T oder 50BF (Schaltversagerschutz) angegeben sind. Es werden z.B. überwacht: Leistungsschalter 12,13, Automatische Spannungskontrolle 14, Erste Transformatorseite 15, Zweite Transformatorseite 16, und Zugangsleitung (Feeder) 17. Das Gerät 29 überwacht: Leistungsschalter 31,32, "Busbar Differential" 33. Das Gerät 30 weist die gleichen Überwachungsfunktionen, hier mit den Bezugszeichen 34-36 gekennzeichnet, wie das Gerät 29 auf.

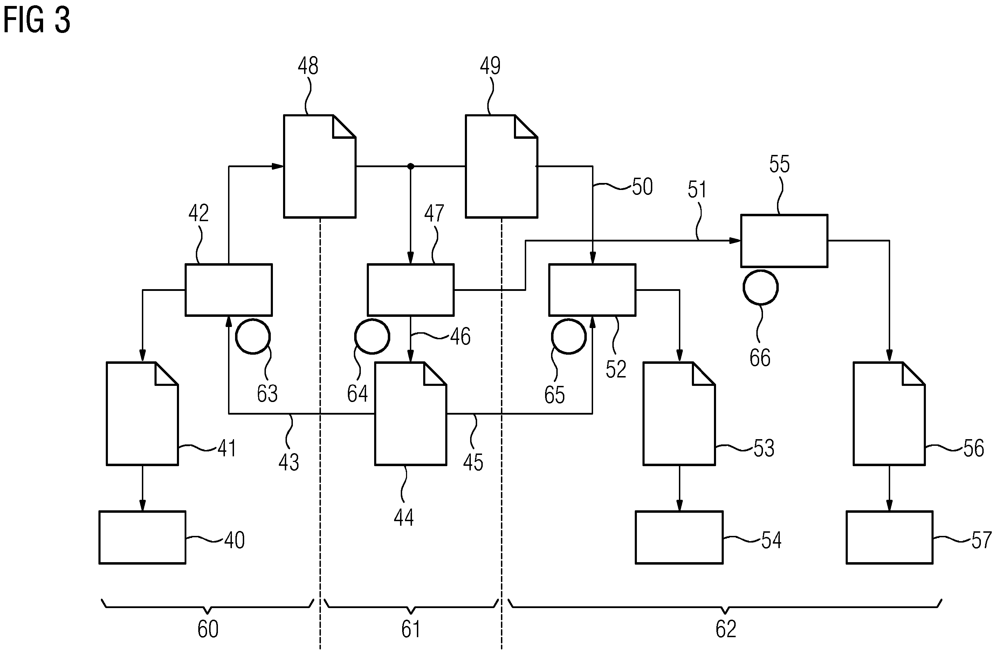

Die Figur 3 zeigt einen bekannten Ablaufplan bzw. Workflow für eine Konfiguration einer Schutzanordnung, wie er für eine Installation mit Prozessbus nach dem Standard IEC61850-6 beispielsweise für das bekannte SIPROTEC Schutzgerät verwendet wird. Das bisherige Engineering der digitalen Strom- und Spannungswandlerkanäle von den Merging Units bis zum Prozessbus-Client ist mit vier verschiedenen Konfigurationstools verknüpft. In der schematischen Darstellung stehen die Bereiche 60,61,62 für unterschiedliche Aspekte der Parametrierung einer Schutzanordnung. Bereich 60 betrifft die Datensammelungseinrichtung bzw. Merging Unit 60, Bereich 61 die Systemkonfiguration und Bereich 62 den Prozessbus bzw. die Datenkommunikationsverbindungen.

Als erstes Konfigurationstool 42 kommt ein sog. "Merging Unit Engineering Tool" zum Einsatz, das z.B. als Softwarekomponente in der eingangs genannten Software DIGSI bereitgestellt werden kann. Dieses Tool stellt eine Konfigurationsdatei 41 für die Datensammelungseinrichtung 40 bereit, so dass diese mittels der Konfigurationsdatei parametriert und betrieben werden kann. Der Wirkbereich des ersten Konfigurationstools ist mit dem Bezugszeichen 63 angedeutet.

Als zweites Konfigurationstool 47 kommt ein herstellerunabhängiger "System Configurator" zum Einsatz. Aus diesem Tool kann eine Konfigurationsdatei 44 "Station SCD file" übermittelt 46 werden, die die Merging Unit und den Client - also das Schutzgerät - zusammenführt. Die Konfigurationsdatei 44 wird an das erste Konfigurationstool 42 übermittelt 43, welches wiederum eine Konfigurationsdatei 48 "Merging Unit IID file" bereitstellt, die in den System Configurator 47 importiert wird. Der Wirkbereich des zweiten Konfigurationstools ist mit dem Bezugszeichen 64 angedeutet.

Als weiterer Input für den System Configurator 47 dient eine Konfigurationsdatei 49 "Prozessbus client IID file", die ferner auch an ein drittes Konfigurationstool 52 "Prozessbus Client Engineering Tool" übermittelt wird 50, das ebenfalls mittels DIGSI bereitgestellt werden kann. Für das dritte Konfigurationstool 52 dient ebenfalls die Konfigurationsdatei 44 als Input, die übermittelt wird 45. Mittels der dritten Konfigurationseinrichtung 52 wird eine weitere Konfigurationsdatei 53 (z.B. ein "SIPROTEC 5 CFG file") erstellt, die zur Konfiguration des "Prozessbus Client Device" 54, z.B. eines Schutzgeräts, verwendet wird. Der Wirkbereich des dritten Konfigurationstools ist mit dem Bezugszeichen 65 angedeutet.

Das vierte Konfigurationstool 55 "Prozessbus Client Configuration Tool" erhält Input 51 vom System Configurator 46, nämlich sog. "SCD import connected channels". Dies ermöglicht die Erstellung einer Konfigurationsdatei 56 "Prozessbus Configuration file", welche einem "Prozessbus Client Board" zur Verfügung gestellt wird. Der Wirkbereich des vierten Konfigurationstools ist mit dem Bezugszeichen 66 angedeutet.

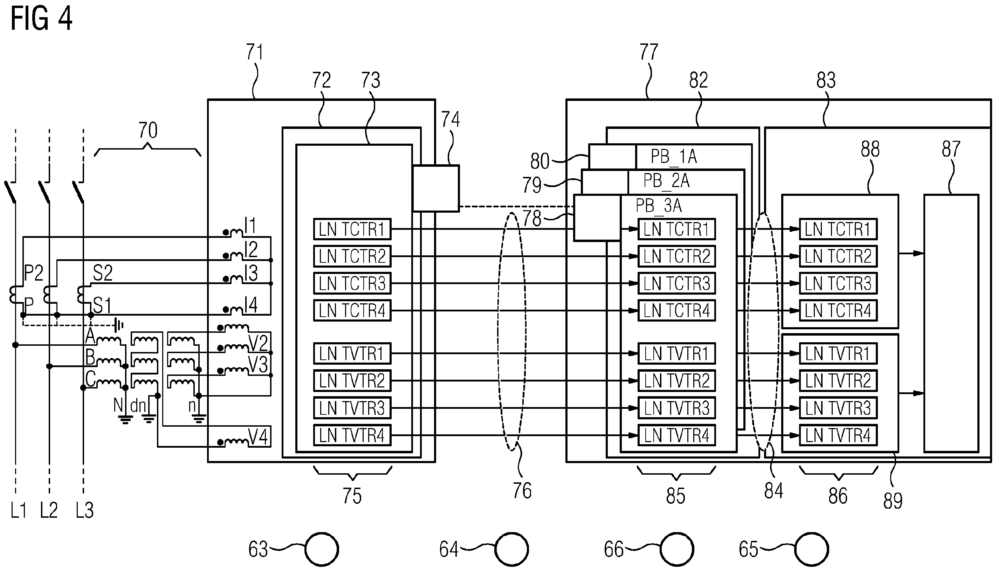

Figur 4 zeigt ein Ausführungsbeispiel einer bekannten Zuordnung von Messwandlerkanälen zu einer Datensammelungseinrichtung und einer Schutzeinrichtung, d.h. eine bisherige Konfigurationszuordnung der digitalen Strom- und Spannungswandlerkanäle von der Merging Unit bis zum Prozessbus-Client.

Ein dreiphasiges elektrisches Energienetz mit den Phasen L1,L2,L3 weist Messwandler 70 als Messeinrichtungen auf, die analog an eine Datensammelungseinrichtung 71 bzw. eine Merging Unit angeschlossen sind. Diese weist eine erste Softwarekomponente 72 auf, die wiederum mit einer Messdatenerfassung 73 ausgestattet ist. Die Messdatenerfassung 73 ordnet jedem analogen Eingangskanal einen "logical node" LN zu (mit Bezugszeichen 75 gekennzeichnet), also z.B. einem Stromwert I1 eine Repräsentation LN TCTR1 ("logical node transformer current transformer 1") oder einem Spannungswert V2 eine Repräsentation LN TVTR2 ("logical node transformer voltage transformer 1"). Die Strom- und Spannungswandler sind als einphasige Elemente TCTR bzw. TVTR abgebildet. Die Strom- und Spannungswandleranschlüsse bzw. die Zuordnung zu den physikalischen Messstellen werden nicht berücksichtigt. Durch die komplexen Projektierungsschritte bzw. vielfachen manuellen Zuordnungen, wie z.B. der geräteinternen Zuordnung werden Fehler ermöglicht. Eine flexible Aufteilung der Eingangskanäle des Prozessbus-Clients in nur benötigte Ströme und Spannungen ist nicht möglich. Die fehlende Flexibilität ist insbesondere bei erhöhter Kanalanzahl nachteilig. Die Konfiguration der Merging Unit fällt in den Wirkbereich 63 des ersten Konfigurationstools gemäß Figur 3.

Die Repräsentationen 75 werden über eine Kommunikationseinrichtung für Ethernet 74 übermittelt. Dabei erfolgt die Zuordnung 76 über Prozessbus zum korrekten Empfängergerät 77 entsprechend einer Konfiguration im Wirkbereich 64 des zweiten Konfigurationstools gemäß Figur 3.

Das Empfängergerät 77 ist ein Schutzgerät, das mehrere Objekte gleichzeitig überwachen bzw. Eingangssignale mehrerer Merging Units parallel verarbeiten kann. Hierfür werden softwaremäßig mehrere Kopien bzw. Instanzen 78,79,80 einer Eingangseinrichtung für Ethernet und einer Prozessbuskonfiguration PB_1A, PB_2A, PB_3A betrieben. Beispielhaft ist die Prozessbuskonfiguration PB_3A dargestellt, die die Repräsentation 85 aus der Merging Unit zur weiteren Verarbeitung bereitstellt. Die Konfiguration des Prozessbusses im Schutzgerät fällt in den Wirkbereich 66 des vierten Konfigurationstools gemäß Figur 3.

Es findet eine Zuordnung 84 der Messwerte bzw. Repräsentationen 85 zur Hauptanwendung Schutzfunktionen 83 statt, insbesondere zu instanziierten Messwertmodulen 88,89 für Strom und Spannung. Diese Konfiguration im Schutzgerät fällt in den Wirkbereich 65 des dritten Konfigurationstools gemäß Figur 3. Werden Schutzfunktionen ausgelöst, so erfolgt eine Übergabe von entsprechenden Auslösesignalen an eine Einrichtung 87 zur Vorbereitung von Steuerbefehlen für einen Leitungsabgang (Feeder). Auf diese Weise kann mittels des Schutzgeräts auf Leistungsschalter im elektrischen Energienetz rückgewirkt werden.

Im Einzelnen umfassen die Konfigurationsschritte für das erste Konfigurationstool 42 (Merging Unit Engineering Tool) mit Wirkbereich 63:
- Vorbereiten der zu übertragenden Strom- und Spannungswandlerkanäle der Merging Unit in Übereinstimmung mit dem IEC61850 Objektmodell
- Parametrieren eines fest vordefinierten Übertragungsumfangs von 4 Strömen und 4 Spannungen gemäß IEC61850-9-2 LE (Lite Edition) TCTR1..4, TVTR1..4 .

Die Konfigurationsschritte für das dritte Konfigurationstool 52 (Prozessbus-Client Engineering Tool) mit Wirkbereich 65 umfassen:
- Instanziierung des Prozessbus-Client Moduls
- zwei feste vordefinierte Konfigurationen von 12 Strömen und 12 Spannungen oder 24 Strömen sind im Prozessbus-Client Modul verfügbar
- Instanziierung der Messstellen im Prozessbus Client analog direkt angeschalteter Kanäle
- Die einzelnen Phasen eines dreiphasigen Messwertmodules werden separat auf die Kanäle des Prozessbus-Client Moduls verschaltet.

Die Konfigurationsschritte für das zweite Konfigurationstool 47 (System Configurator) mit Wirkbereich 64 umfassen:
- Verknüpfung von IID Dateien der Merging Units und der Prozessbus-Clients in einer Stationskonfigurationsdatei (SCD)
- Verbinden der einzelnen einphasigen Stromwandlerinstanzen TCTR bzw. Spannungswandlerinstanzen TVTR der Merging Unit (Source) mit denen des Prozessbus Client (Destination) in der Ansicht "Sampled Measured Values (SMV)".
- Die "Sampled Measured Values (SMV)" stellen z.B. Ströme, Spannungen und Abtastraten der Merging Unit bereit.
- Der Empfänger LN ist der IEC61850 Name aus IED und LN Name des TCTR bzw. TVTR.

Die Konfigurationsschritte für das vierte Konfigurationstool 55 (Prozessbus Client Configuration Tool) mit Wirkbereich 66 umfassen:
- Die Prozessbus Client Konfiguration erfolgt mit einem separaten Prozessbuskonfigurationstool.
- Um ein Signal einer Merging Unit einem Kanal der Prozessbusbaugruppe zuzuordnen gibt es in dem Tool
die Signal-Ansicht. Der Spaltenname in der Messtellenrangiermatrix von DIGSI ist die Referenz zur
Zielspalte.

Im Folgenden soll nun auf die erfindungsgemäßen Verbesserungen des bisherigen Verfahrens eingegangen werden.

Es wird vorgeschlagen, im Merging Unit Engineering Tool eine neue separate Ansicht "Merging Unit Routing" bereitzustellen. Diese ermöglicht zwei Vereinfachungen:
a. Eine Instanziierung eines Messmoduls Strom/Spannung 3-phasig/ 1-phasig aus der Funktionsbibliothek sowie Festlegen der Anschlussartart und Zuordnung zu den Geräteeingangskanälen in der Ansicht Messtellenrangierung.
b. In der neuen Ansicht "Merging Unit Routing" werden die Strom- und Spannungsmessmodule als Einheit den zu versendenden Sampled Values (SV) Streams zugeordnet. Über die Anschlussart wird fest die Anzahl der zu versendenden Kanäle vorgegeben. Ferner ist ein Stream Typ, zum Beispiel IEC61850 9-2 LE, auswählbar.

Dieser Ansatz erlaubt eine vereinfachte Parametrierung der anlogen Eingänge der Merging Units. Es wird folglich die Senderseite in Bezug auf das datenempfangende Schutzgerät konfiguriert.

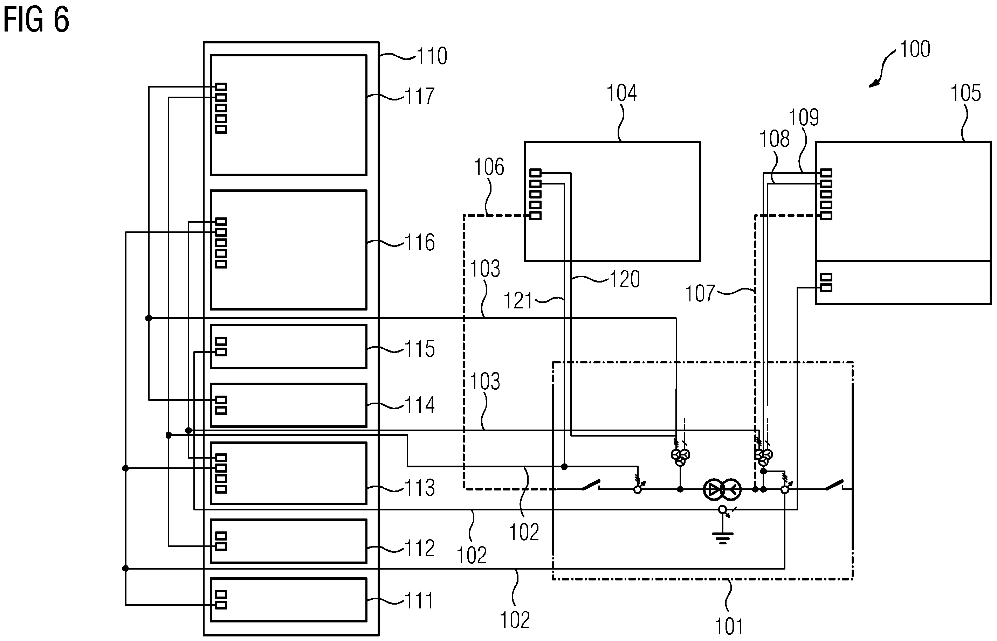

Alternativ ist die Konfiguration der Zuordnung von instanziierbaren Messstellen im Single Line Diagramm auf die IEC 61850 9-2 SV Streams möglich (siehe dazu weiter unten Figur 6 sowie die Ausführungen zur Konfiguration des Prozessbus-Client).

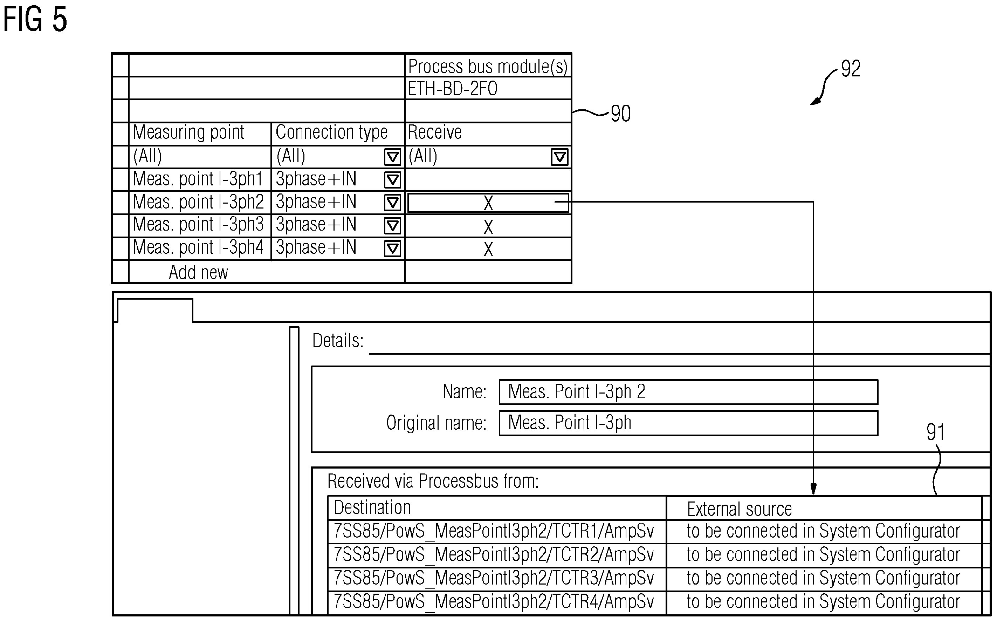

Ferner wird gemäß Figur 5 vorgeschlagen, im Prozessbus-Client Engineering Tool 92 Veränderungen vorzunehmen. Die Funktionalität wird gekennzeichnet durch vereinfachte Konfigurierbarkeit im Engineering Tool durch den Anwender:
- Instanziierung eines Messmoduls Strom/Spannung 3-phasig/ 1-phasig aus der Funktionsbibliothek
- Festlegen der Anschlussartart und Zuordnung zu den Geräteeingangskanälen in der Ansicht Messtellenrangierung 90
- In der Ansicht "Messstellenrangierung" ist eine neue Spalte 91 "Prozessbus" verfügbar. Hier können die Strom- und Spannungsmessmodule als Einheit bzw. Bündel dem Prozessbus zugeordnet werden. Über die Anschlussart wird implizit die Anzahl der zu empfangenen Kanäle vorgegeben. Dieser Ansatz erlaubt eine vereinfachte Parametrierung des Schutzgeräts. Es wird folglich die Empfängerseite in Bezug auf das datenempfangende Schutzgerät konfiguriert.

Durch die implizite Rangierung wird eine flexible und vereinfachte Zuordnung gewährleistet. Im Eigenschaftsfenster der Messstelle wird der Name der Quelle des SV Streams der Merging Unit nach Verbindung im Systemkonfigurationstool angezeigt.

Eine besonders einfache Möglichkeit zur Parametrierung der Schutzanordnung wird gemäß Figur 6 dadurch bereitgestellt, dass die physikalischen Strom- und Spannungswandler im Single Line Editor des Engineering Tools verschaltbar sind. Dazu ist zusätzlich zu der Verschaltung zu den Merging Units eine Kommunikationsverschaltung direkt auf den Prozessbus-Client notwendig. Diese Kommunikationsverschaltung kann in einer realen Software zum Beispiel anders farblich dargestellt werden.

Die Figur 6 zeigt dabei schematisch eine graphische Konfiguration anhand einer "Single Line Diagramm" - Darstellung im Engineering Tool für einen Transformator- und Leitungsschutz entsprechend dem Beispielnetz 101 aus Figur 2. Das Single line diagramm beschreibt die Primäranlage und kann beispielsweise anhand von Informationen aus einem sog. SSD file der Ortsnetzstation automatisiert erstellt werden. Alternativ kann die Primäranlage durch einen Benutzer mittels vordefinierter Komponenten (z.B. Transformator, Messwandler) gezeichnet werden.

Es sind zwei Datensammelungseinrichtungen 104,105 bzw. Merging Units sowie das Schutz- und Steuergerät 110 (entspricht IED01 in Figur 2) vereinfacht dargestellt. Die sieben Funktionsgruppen 11-17 gemäß Figur 2 sind als Kästen 111-117 angedeutet. Der Benutzer kann nun durch einfaches Anklicken von Messtellen und ziehen mit der Maus (oder einem anderen Manipulationsgerät) graphisch eine Verbindung zu einer Funktion im IED/ Schutzgerät oder in der Merging Unit parametrieren. Dies ist eine enorme Vereinfachung des bisher sehr komplexen Konfigurationsverfahrens.

Beispielshaft hat der Benutzer bereits die eingezeichneten Verbindungen graphisch hergestellt, die dann automatisiert in Konfigurationsdateien entsprechend der in den vorhergehenden Figuren beschriebenen Konfigurationstools umgewandelt wurden.

Bei den Datenkommunikationsverbindungen 102 handelt es sich um per Prozessbus übertragene Strommesswerte. Bei den Datenkommunikationsverbindungen 103 handelt es sich um per Prozessbus übertragene Spannungsmesswerte. Datenkommunikationsverbindungen 106,107 beschreiben Transformatorschaltstellungen, die den Merging Units 104,105 übermittelt werden. Die Verbindungen 109,120 übermitteln Spannungsmesswerte von den Transformatoren und die Verbindungen 108,121 übermitteln Stromesswerte von den Transformatoren an die Merging Units 104,105.

Die grafische Zuordnung der Verschaltung im Single Line Diagramm System wird nach Standard IEC61850 in einem "Specification Description file (.ssd)" gespeichert. Anhand dieser Information im SSD File und der Informationen im sog. "ICD File" werden nach einem Algorithmus bzw. einer Applikationsvorlage die Strom- und Spannungswandlerkanäle der Merging Units auf die Prozessbus-Client TCTR/ TVTR automatisiert verschaltet.

Ein Import aus dem Systemkonfigurationstool in das Tool DIGSI zur Einrichtung des Prozessbus-Client erfolgt, indem beim Import der SCD Datei nach DIGSI die Parameter der Stromwandler und Spannungswandler der Merging Units automatisiert in den Prozessbus-Client übernommen werden. Damit wird die Konsistenz aller Einstellungen, zum Beispiel der Parameter für den Primärwandler (Primärnennstrom , Übersetzungsverhältnisse) gesichert.

Zusammenfassend lässt sich feststellen, dass im Vergleich zu Verfahren des Standes der Technik beim erfindungsgemäßen Verfahren die Anwendung der instanziierbaren Messwertmodule Strom 3-phasig / Spannung 3-phasig auf die Konfiguration einer digitalen Prozessbusanwendung nach IEC61850 9-2 die Konfiguration einer Schutzanordnung vereinfacht. Bisher gab es in der Engineering Tool Kette vom Engineering Tool der Merging Unit, zum Systemkonfigurationstool bis zum Engineering Tool des Prozessbus Client keine durchgängige Behandlung der instanziierbaren Messwertmodule. Ein instanziierbares Messwertmodul ist im Sinne der Erfindung ein Bündel - entsprechend der Anschlussart - drei- oder vier zu übertragender Strom- oder Spannungskanäle.

Die Verschaltung wird erfindungsgemäß insbesondere durch folgende neue Elemente bzw. Ansichten vereinfacht:
1.) Neue Ansicht "Merging Unit Routing" im Merging Unit Engineering Tool.
2.) Neue Spalte Prozessbus in der Messstellenrangierung des Prozessbus-Clients.
3.) Grafische Verschaltung von Strom- und Spannungswandler über Prozessbuskommunikation im Single Line Editor.
4.) Automatisiertes Verbinden der Sampled Values Sender und Empfänger im Systemkonfigurationstool anhand der Single Line Konfiguration
5.) Konsistente Datenübernahme der Einstellwerte von den Sender Datenobjekten TCTR/TVTR in die Empfänger Datenobjekte

Hieraus ergeben sich eine Reihe von Vorteilen:
1.) Durch die Übernahme des Konzepts der Instanziierbarkeit der Messmodule und der Konfiguration der Anschaltung mit einem Parameter auf die Prozessbuskonfiguration entfällt die Komplexität der Einzelverschaltungen der Strom- und Spannungswandlerkanäle.
2. Die Instanziierbarkeit der Messmodule in der Merging Unit erlaubt eine hohe Flexibilität hinsichtlich der Übertragung von mehreren Strom- und Spannungsmessstellen oder in unterschiedlichen Prozessbusringen.
3. Durch eine Beschränkung auf die genutzte Kanalanzahl im Prozessbus-Client ergibt sich eine optimale Skalierung hinsichtlich der verwendeten internen Ressourcen (Bandbreite).
4. Die automatisierte Verschaltung im Systemkonfigurationstool und die Anwendung von Applikationsvorlagen spart Aufwand bei der Projektierung und reduziert mögliche Fehlverdrahtungen.
5. Die Usability der Projektierung wird durch die grafische Zuordnung und Visualisierung im Single Line Editor verbessert.

## Patentansprüche

1. Verfahren zum Parametrieren einer Schutzanordnung (200,201,202) für ein elektrisches Energienetz (L1,L2,L3), mit den Schritten:
Zuordnen von Ausgabekanälen (I1,I2,I3,I4,V1,V2,V3,V4) von Messeinrichtungen (70) zu Eingabekanälen (75) einer Datensammelungseinrichtung (71) mittels einer ersten Konfigurationseinrichtung, und
Parametrieren von Kommunikationsverbindungen (76) zwischen der Datensammelungseinrichtung (71) und einer Schutzeinrichtung (77) mittels einer zweiten Konfigurationseinrichtung,
**dadurch gekennzeichnet, dass**
die Zuordnung der Messeinrichtungen (70) und die Parametrierung der Kommunikationsverbindungen (76) mittels einer dritten Konfigurationseinrichtung anhand eines Single-line Diagramms (100) vorgegeben werden, und
dass für die Kommunikationsverbindungen Prozessbus verwendet wird.

2. Verfahren nach Anspruch 1, **dadurch gekennzeichnet, dass** die parametrierte Schutzanordnung (200,201,202) für den Betrieb des elektrischen Energienetzes (L1,L2,L3) eingesetzt wird, um mindestens einen Transformator und mindestens einen Leitungseingang zu überwachen und zu schützen.

3. Verfahren nach Anspruch 2, **dadurch gekennzeichnet, dass** die Kommunikationsverbindungen zwei redundante Prozessbusringe (19,20) aufweisen.

4. Verfahren nach einem der vorhergehenden Ansprüche, **dadurch gekennzeichnet, dass** das Zuordnen der Ausgabekanäle (I1,I2,I3,I4,V1,V2,V3,V4) von Messeinrichtungen (70) zu Eingabekanälen (75) der Datensammelungseinrichtung (71) jeweils mittels Messwertmodulen (88,89) erfolgt, die Messwerte von dreiphasiger Spannung und/oder dreiphasigem Strom jeweils bündeln.

5. Verfahren nach Anspruch 4, **dadurch gekennzeichnet, dass** die Messwertmodule (88,89) in der Schutzeinrichtung (70) für Schutzfunktionen (87) verwendet werden.

6. Verfahren nach Anspruch 4 oder 5, **dadurch gekennzeichnet, dass** die Messwertmodule (88,89) derart instanziierbar sind, dass mehrere elektrische Betriebsmittel über dieselbe Datensammelungseinrichtung (71) und eine einzige Schutzeinrichtung (77) überwacht und geschützt werden.

7. Schutzanordnung (200,201,202) für ein elektrisches Energienetz (L1,L2,L3), aufweisend
eine erste Konfigurationseinrichtung, die ausgebildet ist, Ausgabekanäle (I1,I2,I3,I4,V1,V2,V3,V4) von Messeinrichtungen (70) zu Eingabekanälen (75) einer Datensammelungseinrichtung (71) zuzuordnen, und
eine zweite Konfigurationseinrichtung, die ausgebildet ist, Kommunikationsverbindungen (76) zwischen der Datensammelungseinrichtung (71) und einer Schutzeinrichtung (77) zu parametrieren,
**dadurch gekennzeichnet, dass**
eine dritte Konfigurationseinrichtung ausgebildet ist,
die Zuordnung der Messeinrichtungen (70) und die Parametrierung der Kommunikationsverbindungen (76) anhand eines Single-line Diagramms (100) vorzugeben, und
dass die zweite Konfigurationseinrichtung ausgebildet ist, für die Kommunikationsverbindungen Prozessbus zu verwenden.

8. Schutzanordnung nach Anspruch 7, **dadurch gekennzeichnet, dass** die parametrierte Schutzanordnung (200,201,202) ausgebildet ist, im laufenden Betrieb des elektrischen Energienetzes (L1,L2,L3) Schutzfunktionen bereit zu stellen, um mindestens einen Transformator und mindestens einen Leitungsabgang zu überwachen und zu schützen.

9. Schutzanordnung nach Anspruch 8, **dadurch gekennzeichnet, dass** die Kommunikationsverbindungen zwei redundante Prozessbusringe (19,20) aufweisen.

10. Schutzanordnung nach einem der Ansprüche 7 bis 9, **dadurch gekennzeichnet, dass** die erste Konfigurationseinrichtung ausgebildet ist, das Zuordnen der Ausgabekanäle (I1,I2,I3,I4,V1,V2,V3,V4) von Messeinrichtungen (70) zu Eingabekanälen (75) der Datensammelungseinrichtung (71) jeweils mittels Messwertmodulen (88,89) durchzuführen, die Messwerte von dreiphasiger Spannung und/oder dreiphasigem Strom jeweils bündeln.

11. Schutzanordnung nach Anspruch 10, **dadurch gekennzeichnet, dass** die Schutzeinrichtung (70) ausgebildet ist, die Messwertmodule (88,89) für Schutzfunktionen (87) zu verwenden.

12. Schutzanordnung nach Anspruch 10 oder 11, **dadurch gekennzeichnet, dass** die für die Schutzanordnung verwendeten Messwertmodule (88,89) derart instanziierbar ausgebildet sind, dass mehrere elektrische Betriebsmittel über dieselbe Datensammelungseinrichtung (71) und eine einzige Schutzeinrichtung (77) überwacht und geschützt werden.

13. Computerprogrammprodukt, das computerausführbare Programmmittel aufweist und bei Ausführung auf einer Rechnereinrichtung mit Prozessormitteln und Datenspeichermitteln ein Verfahren nach einem der Ansprüche 1 bis 6 durchführt.

## Claims

1. Method for parameterizing a protective arrangement (200,201,202) for an electrical energy network (L1,L2,L3), having the steps of:
assigning output channels (I1,I2,I3,I4,V1,V2,V3,V4) of measuring devices (70) to input channels (75) of a data collection device (71) by means of a first configuration device, and
parameterizing communication connections (76) between the data collection device (71) and a protective device (77) by means of a second configuration device,
**characterized in that**
the assignment of the measuring devices (70) and the parameterization of the communication connections (76) are predefined by means of a third configuration device using a single-line diagram (100), and
**in that** process bus is used for the communication connections.

2. Method according to Claim 1, **characterized in that** the parameterized protective arrangement (200,201,202) is used for the operation of the electrical energy network (L1,L2,L3) in order to monitor and protect at least one transformer and at least one line input.

3. Method according to Claim 2, **characterized in that** the communication connections have two redundant process bus rings (19,20).

4. Method according to one of the preceding claims, **characterized in that** the output channels (I1,I2,I3,I4,V1,V2,V3,V4) of measuring devices (70) are each assigned to input channels (75) of the data collection device (71) by means of measured value modules (88,89) which each bundle measured values of three-phase voltage and/or three-phase current.

5. Method according to Claim 4, **characterized in that** the measured value modules (88,89) are used in the protective device (70) for protective functions (87).

6. Method according to Claim 4 or 5, **characterized in that** the measured value modules (88,89) can be instantiated in such a way that a plurality of items of electrical equipment are monitored and protected via the same data collection device (71) and a single protective device (77).

7. Protective arrangement (200,201,202) for an electrical energy network (L1,L2,L3), having
a first configuration device which is designed to assign output channels (I1,I2,I3,I4,V1,V2,V3,V4) of measuring devices (70) to input channels (75) of a data collection device (71), and
a second configuration device which is designed to parameterize communication connections (76) between the data collection device (71) and a protective device (77),
**characterized in that**
a third configuration device is designed to predefine the assignment of the measuring devices (70) and the parameterization of the communication connections (76) on the basis of a single-line diagram (100), and
**in that** the second configuration device is designed to use process bus for the communication connections.

8. Protective arrangement according to Claim 7, **characterized in that** the parameterized protective arrangement (200,201,202) is designed to provide protective functions during operation of the electrical energy network (L1,L2,L3) in order to monitor and protect at least one transformer and at least one line outlet.

9. Protective arrangement according to Claim 8, **characterized in that** the communication connections have two redundant process bus rings (19,20).

10. Protective arrangement according to one of Claims 7 to 9, **characterized in that** the first configuration device is designed to assign each of the output channels (I1,I2,I3,I4,V1,V2,V3,V4) of measuring devices (70) to input channels (75) of the data collection device (71) by means of measured value modules (88,89) which each bundle measured values of three-phase voltage and/or three-phase current.

11. Protective arrangement according to Claim 10, **characterized in that** the protective device (70) is designed to use the measured value modules (88,89) for protective functions (87).

12. Protective arrangement according to Claim 10 or 11, **characterized in that** the measured value modules (88,89) used for the protective arrangement are designed to be able to be instantiated in such a way that a plurality of items of electrical equipment are monitored and protected via the same data collection device (71) and a single protective device (77).

13. Computer program product which has computer-executable program means and, when executed on a computer device with processor means and data storage means, carries out a method according to one of Claims 1 to 6.

## Revendications

1. Procédé de paramétrage d'un agencement (200, 201, 202) de protection d'un réseau (L1, L2, L3) d'énergie électrique, comprenant les stades :
association de canaux (I1, I2, I3, I4, V1, V2, V3, V4) de sortie de dispositifs (70) de mesure à des canaux (75) d'entrée d'un dispositif (71) de collecte de données, au moyen d'un premier dispositif de configuration, et
paramétrage de liaisons (76) de communication entre le dispositif (71) de collecte de données et un dispositif (77) de protection, au moyen d'un deuxième dispositif de configuration,
**caractérisé en ce que** l'
on prescrit l'association des dispositifs (70) de mesure et le paramétrage des liaisons (76) de communication au moyen d'un troisième dispositif de configuration à l'aide d'un diagramme (100) single-line, et
**en ce que** l'on utilise un bus de processus pour les liaisons de communication.

2. Procédé suivant la revendication 1, **caractérisé en ce que** l'on utilise l'agencement (200, 201, 202) de protection paramétré pour le fonctionnement du réseau (L1, L2, L3) d'énergie électrique, afin de contrôler et de protéger au moins un transformateur et au moins une entrée de ligne.

3. Procédé suivant la revendication 2, **caractérisé en ce que** les liaisons de communication ont deux anneaux (19, 20) de bus de processus redondants.

4. Procédé suivant l'une des revendications précédentes, **caractérisé en ce que** l'association des canaux (I1, I2, I3, I4, V1, V2, V3, V4) de sortie des dispositifs (70) de mesure aux canaux (75) d'entrée du dispositif (71) de collecte de données s'effectue respectivement au moyen de modules (88, 89) de valeur de mesure, qui mettent en faisceau respectivement des valeurs de mesure de la tension triphasée et/ou du courant triphasé.

5. Procédé suivant la revendication 4, **caractérisé en ce que** l'on utilise les modules (88, 89) de valeur de mesure dans le dispositif (70) de protection pour des fonctions (87) de protection.

6. Procédé suivant la revendication 4 ou 5, **caractérisé en ce que** l'on peut instancier les modules (88, 89) de valeur de mesure, de manière à contrôler et à protéger plusieurs moyens de fonctionnement électrique par le même dispositif (71) de collecte de données et un seul dispositif (77) de protection.

7. Agencement (200, 201, 202) de protection d'un réseau (L1, L2, L3) d'énergie électrique, comportant
un premier dispositif de configuration, qui est constitué pour associer des canaux (I1, I2, I3, I4, V1, V2, V3, V4) de sortie de dispositifs (70) de mesure à des canaux (75) d'entrée d'un dispositif (71) de collecte de données, et
un deuxième dispositif de configuration, qui est constitué pour paramétrer des liaisons (76) de communication entre le dispositif (71) de collecte de données et un dispositif (77) de protection,
**caractérisé en ce qu'**
un troisième dispositif de configuration est constitué
pour prescrire, à l'aide d'un diagramme (100) single-line, l'association des dispositifs (70) de mesure et le paramétrage des liaisons (76) de communication, et
**en ce que** le deuxième dispositif de configuration est constitué pour utiliser un bus de processus pour les liaisons de communication.

8. Agencement suivant la revendication 7, **caractérisé en ce que** l'agencement (200, 201, 202) de protection paramétré est constitué pour disposer, dans le fonctionnement courant du réseau (L1, L2, L3) d'énergie électrique, de fonctions de protection, afin de contrôler et de protéger au moins un transformateur et au moins une sortie de ligne.

9. Agencement suivant la revendication 8, **caractérisé en ce que** les liaisons de communication ont deux anneaux (19, 20) de bus de processus redondants.

10. Agencement suivant l'une des revendications 7 à 9, **caractérisé en ce que** le premier dispositif de configuration est configuré pour effectuer l'association des canaux (I1, I2, I3, I4, V1, V2, V3, V4) de sortie de dispositifs (70) de mesure à des canaux (75) d'entrée du dispositif (71) de collecte de données respectivement au moyen de modules (88, 89) de valeur de mesure, qui mettent en faisceau respectivement des valeurs de mesure de la tension triphasée et/ou du courant triphasé.

11. Agencement suivant la revendication 10, **caractérisé en ce que** le dispositif (70) de protection est constitué pour utiliser les modules (88, 89) de valeur de mesure pour des fonctions (87) de protection.

12. Agencement suivant la revendication 10 ou 11, **caractérisé en ce que** les modules (88, 89) de valeur de mesure utilisés pour l'agencement de protection sont constitués pour pouvoir être instanciés, de manière à contrôler et à protéger plusieurs moyens de fonctionnement électrique par le même dispositif (71) de collecte de données et par un seul dispositif (77) de protection.

13. Produit de programme d'ordinateur, qui a des moyens de programme pouvant être exécuté par un ordinateur et qui, lors de l'exécution sur un dispositif informatique ayant des moyens de processeur et des moyens de mémoire de données, exécute un procédé suivant l'une des revendications 1 à 6.
